# FASCICULE DE BREVET EUROPEEN

(11) **EP 3 667 503 B1**
(45) Date de publication et mention de la délivrance du brevet: **17.05.2023**
(21) Numéro de dépôt: 19211033.6
(22) Date de dépôt: 22.11.2019
(51) Int. Cl.: G06F 11/10, G06F 12/02

(54) **PROCÉDÉ DE GESTION DE L'ESPACE MÉMOIRE D'UN DISPOSITIF DE MÉMOIRE ET SYSTÈME CORRESPONDANT**
VERWALTUNGSVERFAHREN DES SPEICHERPLATZES EINER SPEICHERVORRICHTUNG UND ENTSPRECHENDES SYSTEM
METHOD FOR MANAGING THE MEMORY SPACE OF A MEMORY DEVICE AND CORRESPONDING SYSTEM

(30) Priorité: 03.12.2018 FR 1872239
(43) Date de publication de la demande: 17.06.2020
(73) Titulaire: STMicroelectronics (Rousset) SAS, 13790 Rousset (FR)
(72) Inventeur: GRIL-MAFFRE, Jean-Michel, 13090 Aix-en-Provence (FR); EVA, Christophe, 13790 Rousset (FR)
(74) Mandataire: Casalonga

(56) Documents cités:
- KR-B1- 101 512 927
- US-A1- 2006 059 298

## Description

Des modes de mise en oeuvre et de réalisation de l'invention concernent la gestion de l'espace-mémoire d'un dispositif de mémoire, en particulier un dispositif de mémoire volatile, par exemple un dispositif de mémoire vive statique (SRAM : Static Random Access Memory), en particulier lorsque l'utilisation d'un code correcteur d'erreurs (ECC : Error Correction Code) est optionnelle.

Un code correcteur d'erreurs est bien connu de l'homme du métier et permet de corriger la valeur logique erronée d'un bit. Plus précisément, avec un code correcteur d'erreurs, si l'on ajoute s bits de contrôle à b bits de données on peut corriger r erreurs parmi les b+s bits.

Lorsque l'on souhaite mettre en oeuvre un code correcteur d'erreurs, la taille de la mémoire contenant les données et les bits de contrôle est plus importante que la taille d'une mémoire destinée à stocker des données sans utilisation de code correcteur d'erreurs.

A titre indicatif, une mémoire statique destinée à stocker des données sur une largeur de 32 bits (mots de 32 bits) présente une largeur additionnelle de 7 bits pour le stockage des bits de contrôle, ce qui conduit à une largeur globale de 39 bits, de façon à pouvoir stocker des mots de 39 bits.

Il en résulte une augmentation de surface de 22% par rapport à une mémoire de 32 bits non prévue pour stocker des bits de contrôle.

Dans le cas où un utilisateur ne veut pas utiliser de code correcteur d'erreurs dans une application particulière, cette zone mémoire additionnelle de 22% ne sera jamais utilisée car non accessible pour un stockage de données. Or, cette surface mémoire perdue a un impact direct dans les courants de fuite, ce qui n'est pas négligeable pour des produits basse consommation.

L'ajout de surface mémoire a également un impact sur le coût du dispositif.

Il existe donc un besoin de remédier à cet inconvénient et de proposer une plus grande flexibilité dans la gestion de l'espace mémoire d'une mémoire de façon à prendre en compte le caractère optionnel de l'utilisation d'un code correcteur d'erreurs.

US 2006/059298 A1 décrit un système selon le préambule de la revendication 1 et un procédé selon le préambule de la revendication 11.

La présente invention est définie par les revendications indépendantes jointes auxquelles il convient de se référer. Des caractéristiques avantageuses sont exposées dans les revendications dépendantes.

Selon l'invention, il est proposé une mémoire capable de stocker des données et des bits de contrôle de code correcteur d'erreurs et de pouvoir éventuellement réutiliser l'espace mémoire prévu pour ces bits de contrôle, à des fins de stockage de données au cas où dans certaines applications, il n'est pas prévu d'utiliser de code correcteur d'erreurs.

Selon un aspect, il est proposé un système comprenant un dispositif de mémoire comportant un premier domaine mémoire destiné à stocker des premières données à des premières adresses et un deuxième domaine mémoire destiné à stocker, sur commande, soit des deuxièmes données à des deuxièmes adresses, soit des bits de contrôle de code correcteur d'erreurs associés aux premières données à des troisièmes adresses.

Selon un mode de réalisation, le système comprend en outre des moyens de traitement configurés pour déterminer avantageusement les troisièmes adresses à partir des premières adresses.

Ceci permet une simplification dans le calcul des troisièmes adresses et permet de relier l'adresse d'un mot de contrôle associé à un mot de données avec l'adresse de ce mot de données de façon à pouvoir retrouver très facilement le mot de contrôle dans le deuxième domaine mémoire.

Selon un mode de réalisation, le système comprend une interface.

Cette interface est configurée pour recevoir les premières données ainsi que des premières adresses initiales associées à ces premières données.

L'interface est également configurée pour recevoir éventuellement les deuxièmes données ainsi que des deuxièmes adresses initiales associées à ces deuxièmes données.

L'interface est également configurée pour délivrer les premières adresses à partir des premières adresses initiales et les deuxièmes adresses à partir des deuxièmes adresses initiales.

En effet, les premières et deuxièmes adresses initiales sont véhiculées en général sur un bus et en fonction de l'architecture du système et de la taille du dispositif de mémoire, les premières adresses et les deuxièmes adresses dans le dispositif de mémoire peuvent être identiques aux ou différentes des premières et deuxièmes adresses initiales.

Ainsi, par exemple, les premières et deuxièmes adresses initiales peuvent être codées sur 17 bits alors que les premières et deuxièmes adresses peuvent être codées sur 15 bits obtenus par exemple par troncature de deux bits des adresses initiales.

Le système comprend également un module de code correcteur d'erreurs configuré pour déterminer les bits de contrôle associés auxdites premières données.

Le système comprend également des moyens de traitement configurés pour déterminer les troisièmes adresses des bits de contrôle et des moyens de commande configurés pour délivrer au deuxième domaine mémoire soit les deuxièmes données et lesdites deuxièmes adresses soit les bits de contrôle et les troisièmes adresses.

Selon un mode de réalisation, le premier domaine mémoire comprend au moins une première zone mémoire ayant une première taille mémoire, par exemple n kbits avec n pouvant être égal à 32 ou 64 sans que ces valeurs ne soient limitatives, et le deuxième domaine mémoire comporte une deuxième zone mémoire ayant également ladite première taille.

Ladite au moins une première zone mémoire et la deuxième zone mémoire comportent des rangées.

Et, selon un mode de réalisation, les moyens de traitement sont configurés pour déterminer lesdites troisièmes adresses de sorte que les bits de contrôle associés aux premières données stockées dans un premier nombre de rangées successives de ladite au moins une première zone mémoire, soient stockés dans un deuxième nombre de rangées de la deuxième zone mémoire inférieur au premier nombre.

Plus particulièrement, lorsque chaque rangée de ladite au moins une première zone mémoire et chaque rangée de la deuxième zone mémoire sont configurées pour stocker des mots de p octets, les moyens de traitement sont configurés pour déterminer lesdites troisièmes adresses de sorte que les bits de contrôle associés aux premières données stockées dans p rangées successives de ladite au moins une première zone mémoire, soient stockés dans les p octets d'une rangée de la deuxième zone mémoire.

Ainsi si par exemple chaque rangée a la capacité de stocker des mots de 32 bits (4 octets), les bits de contrôle associés aux mots de données de 32 bits stockés dans 4 rangées successives de la première zone mémoire, seront stockés dans les 4 octets d'une rangée de la deuxième zone mémoire.

Si par exemple chaque rangée a la capacité de stocker des mots de 64 bits (8 octets), les bits de contrôle associés aux mots de données de 64 bits stockés dans 8 rangées successives de la première zone mémoire, seront stockés dans les 8 octets d'une rangée de la deuxième zone mémoire.

En pratique, le premier domaine mémoire peut comporter plusieurs premières zones mémoires, par exemple mais non limitativement 4 premières zones mémoires, ayant chacune ladite première taille mémoire, par exemple 64 kbits.

Plus particulièrement, si p désigne comme indiqué ci-avant le nombre d'octets que peut stocker une rangée, le premier domaine mémoire peut comporter k.p premières zones mémoire et le deuxième domaine mémoire peut comporter k deuxièmes zones mémoires, k étant un entier supérieur ou égal à 1.

Le dispositif de mémoire peut être un dispositif de mémoire volatile, par exemple une mémoire statique à accès aléatoire (SRAM) mais également une mémoire non volatile par exemple une mémoire du type EEPROM, sans que ces exemples ne soient limitatifs.

Selon un autre aspect, il est proposé un procédé de gestion de l'espace mémoire d'un dispositif de mémoire comportant un premier domaine mémoire et un deuxième domaine mémoire, le procédé comprenant un stockage de premières données à des premières adresses dans le premier domaine et, sur commande, soit un stockage dans le deuxième domaine mémoire de deuxièmes données à des deuxièmes adresses, soit un stockage dans le deuxième domaine mémoire de bits de contrôle de code correcteur d'erreurs associés aux premières données à des troisièmes adresses.

Selon un mode de mise en oeuvre, le procédé comprend une détermination des troisièmes adresses à partir des premières adresses.

La détermination des troisièmes adresses comporte avantageusement des troncatures des premières adresses.

Selon un mode de mise en oeuvre, le procédé comprend
une réception des premières données ainsi que de premières adresses initiales associées aux premières données et éventuellement une réception des deuxièmes données ainsi que de deuxièmes adresses initiales associées à ces deuxièmes données,
une élaboration des premières adresses à partir des premières adresses initiales et une élaboration des deuxièmes adresses à partir des deuxièmes adresses initiales,
une détermination des bits de contrôle associés auxdites premières données,
une détermination des troisièmes adresses des bits de contrôle, et,
sur commande, une délivrance au deuxième domaine mémoire soit desdites deuxièmes données et desdites deuxièmes adresses soit des bits de contrôle et des troisièmes adresses.

Selon un mode de mise en oeuvre, le premier domaine mémoire comprend au moins une première zone mémoire ayant une première taille mémoire et le deuxième domaine mémoire comporte une deuxième zone mémoire ayant également ladite première taille mémoire.

Selon un mode de mise en oeuvre, ladite au moins une première zone mémoire et la deuxième zone mémoire comportent des rangées, et les bits de contrôle associés aux premières données stockées dans un premier nombre de rangées successives de ladite au moins une première zone mémoire, sont stockés dans un deuxième nombre de rangées de la deuxième zone mémoire inférieur au premier nombre.

Selon un mode de mise en oeuvre, chaque rangée de ladite au moins une première zone mémoire et chaque rangée de la deuxième zone mémoire sont configurées pour stocker des mots de p octets, et les bits de contrôle associés aux premières données stockées dans p rangées successives de ladite au moins une première zone mémoire, sont stockés dans les p octets d'une rangée de la deuxième zone mémoire.

Selon un mode de mise en oeuvre, le premier domaine mémoire comporte plusieurs zones mémoires ayant chacune ladite première taille mémoire.

Selon un mode de mise en oeuvre, le premier domaine mémoire comporte k.p premières zones mémoire et le deuxième domaine mémoire comporte k deuxièmes zones mémoires, k étant un entier supérieur ou égal à 1.

Le dispositif de mémoire peut être un dispositif de mémoire volatile.

D'autres avantages et caractéristiques de l'invention apparaîtront à l'examen de la description détaillée de modes de mise en oeuvre et de réalisation de l'invention, nullement limitatifs, et des dessins annexés sur lesquels
[Fig. 1] illustre un mode de réalisation d'un dispositif de mémoire selon l'invention dans une première configuration,
[Fig. 2] illustre un mode de réalisation d'un dispositif de mémoire selon l'invention dans une deuxième configuration,
[Fig. 3] illustre un mode de réalisation d'un système selon l'invention,
[Fig. 4] illustre partiellement un mode de mise en oeuvre du procédé selon l'invention,
[Fig. 5] illustre partiellement un mode de mise en oeuvre du procédé selon l'invention,
[Fig. 6] illustre partiellement un mode de mise en oeuvre du procédé selon l'invention, et
[Fig. 7] illustre partiellement un exemple de mise en oeuvre de l'invention.

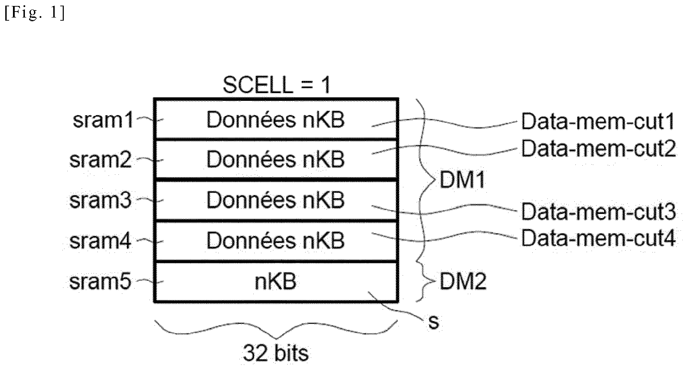

Sur la figure 1, la référence DMM désigne un dispositif de mémoire, ici un dispositif de mémoire volatile, comportant un premier domaine mémoire DM1 et un deuxième domaine mémoire DM2.

Le premier domaine mémoire DM1 comporte quatre zones mémoire sram1, sram2, sram3 et sram4 de taille mémoire identique.

Dans l'exemple illustré ici, ces zones mémoire sont formées par des mémoires vives statiques distinctes. Cela étant, il serait également envisageable que ces zones mémoires soient des zones mémoire d'une même mémoire.

Le deuxième domaine mémoire DM2 comporte une zone mémoire sram5, de taille mémoire identique à celle des zones mémoire sram 1-sram4.

Là encore, la zone mémoire sram5 est une mémoire vive statique.

Dans l'exemple décrit ici, la largeur du dispositif de mémoire est égale à 32 bits, c'est-à-dire qu'on peut stocker des mots de données de 32 bits comportant chacun quatre octets.

La taille mémoire est égale à n kbits, par exemple 64 kbits.

Les zones mémoire sram1-sram4 sont destinées à stocker respectivement des données Data-mem-cut1-4.

Dans la configuration illustrée sur la figure 1, la zone mémoire sram5 est destinée à comporter les bits de contrôle de code correcteur d'erreurs associés aux données stockées dans les zones mémoire sram 1-sram4.

Ceci est fait sur commande d'un signal SCECC qui, dans ce cas, prend par exemple la valeur logique 1.

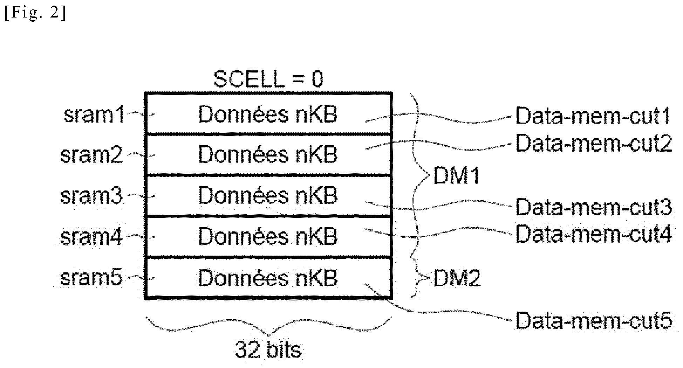

La figure 2 illustre une autre configuration du dispositif de mémoire DMM dans laquelle cette fois-ci la zone mémoire sram5 est destinée à stocker des deuxièmes données Data-mem-cut5.

Ceci correspond au cas où un utilisateur ne souhaiterait pas utiliser de code correcteur d'erreurs mais souhaiterait utiliser par contre l'espace disponible de la zone mémoire sram5 pour y stocker des données.

Dans ce cas, le signal de commande SCECC est égal à 0.

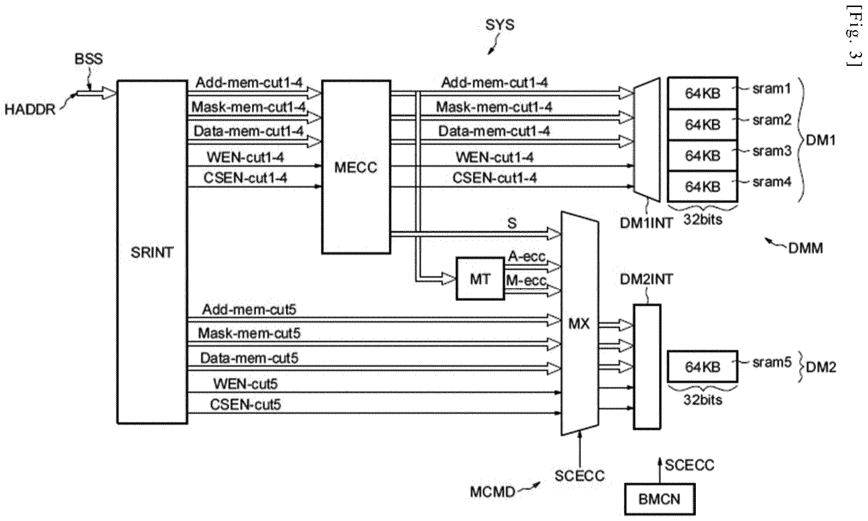

On se réfère maintenant plus particulièrement à la figure 3 pour décrire un mode de réalisation d'un système selon l'invention.

Le système SYS comporte une interface SRINT connectée à un bus BSS qui peut être de toute structure classique et par exemple un bus AHB utilisant un protocole décrit par exemple dans le document AMBA 3 AHB-Lite Protocol V1.0 Spécification, de la société ARM (2001, 2006).

Ce bus véhicule notamment les premières données Data-mem-cut1-4, des premières adresses initiales HADRR associées aux premières données, éventuellement les deuxièmes données Add-memory-cut5 et leurs deuxièmes adresses initiales HADRR, ainsi que d'autres signaux classiques de bus non représentés ici à des fins de simplification.

L'interface SRINT, de structure classique et connue en soi, est configurée pour délivrer des premières adresses associées aux premières données Data-mem-cut1-4 et pour délivrer éventuellement des deuxièmes adresses associées aux deuxièmes données Data-mem-cut5.

Ces première et deuxième adresses sont respectivement tirées des premières et deuxièmes adresses initiales HADRR qui étaient véhiculées sur le bus BSS.

Les premières et deuxièmes adresses pourraient être identiques aux premières adresses initiales. Cela étant, en fonction de l'architecture du système, et notamment de la largeur des zones mémoire, les premières et deuxièmes adresses peuvent être obtenues à partir des premières et deuxièmes adresses initiales par troncature d'un ou de plusieurs bits.

Dans l'exemple décrit ici, on peut écrire dans chaque rangée d'une zone mémoire srami, i égal à 1, 2, 3, ou 4, un mot de 32 bits composé de 4 octets de 8 bits.

Ainsi, dans cet exemple, les références Add-mem-cut1-4 désignent les adresses d'une rangée des zones mémoire sram1-4 et la référence Mask-mem-cut1-4 désigne le numéro de l'octet dans la rangée désignée de la zone mémoire considérée.

Ainsi, les adresses Add-mem-cut1-4 et les masques Mask-mem-cut1-4 forment lesdites premières adresses.

De même, l'adresse Add-mem-cut5 et le masque Mask-mem-cut5 forment la deuxième adresse associée à une deuxième donnée Data-mem-cut5.

Les signaux WEN-cut-1-4 et WEN-cut5 sont des signaux classiques de commande d'écriture dans les différentes zones mémoire et les signaux CSEN-cut1-4 et CSEN-cut5 sont des signaux classiques de sélection de la zone mémoire considérée.

Le système SYS comporte également un module de code correcteur d'erreurs MECC, de structure classique et connue en soi, configuré pour déterminer les bits de contrôle associés auxdites premières données Data-mem-cut1-4.

Plus précisément, pour un mot de quatre octets stocké dans une rangée d'une zone mémoire sram1-4, la référence S désigne les s bits de contrôle associés à ce mot de 4 octets.

S est, dans le cas d'un mot de 32 bits, un mot de 7 bits. En conséquence, S peut être stocké dans un octet de la zone mémoire sram5.

Si la largeur de la mémoire était de 64 bits et non de 32 bits, S aurait une longueur de 8 bits, ce qui pourrait encore être stocké dans un octet de la mémoire sram5.

Comme il est classique, pour écrire un nouveau mot de 32 bits dans une rangée de l'une des zones mémoire sram1 à sram4, on procède tout d'abord à la lecture du mot déjà stocké dans cette rangée.

Puis, le module de code correcteur d'erreurs MECC détermine un syndrome à partir des bits de données et de l'ensemble S des bits de contrôle.

On rappelle ici qu'un syndrome est le résultat des calculs intermédiaires effectués lors de la correction d'erreur permettant de détecter et de localiser l'erreur.

Si un bit est défectueux, le bloc MECC détecte effectivement ce bit défectueux et procède à sa correction.

Avant d'écrire le nouveau mot à l'adresse du mot précédent dans la zone mémoire correspondante, le bloc MECC calcule le nouvel ensemble S des nouveaux bits de contrôle correspondant aux nouveaux octets de données. A cet égard, le nouvel ensemble S des bits de contrôle est calculé avec, le cas échéant, la valeur corrigée du bit défectueux.

Puis, le nouveau mot est écrit dans la zone mémoire correspondante à la première adresse correspondante.

Quant au nouvel ensemble S de bits de contrôle, il est, comme illustré sur la figure 3, délivrés à une entrée d'un multiplexeur MX.

Le système SYS comporte également des moyens de traitement MT configurés pour déterminer des troisièmes adresses de stockage de ces bits de contrôle S.

Ces bits de contrôle S seront en effet stockés dans la zone mémoire sram5.

Une troisième adresse comporte ici l'adresse A-ecc d'une rangée de la zone mémoire sram5 ainsi qu'un masque M-ecc permettant de sélectionner dans ladite rangée, l'un des 4 octets.

Comme on le verra plus en détails ci-après, ces troisièmes adresses sont déterminées à partir des premières adresses et plus précisément, à partir des adresses de rangées Add-mem-cut1-4.

Le système SYS comporte également des moyens de commande MCMD configurés pour délivrer au deuxième domaine mémoire, c'est-à-dire ici à la zone mémoire sram5, soit les deuxièmes données Data-mem-cut5 et les deuxièmes adresses associées Add-mem-cut5, Mask-mem-cut5, soit les bits de contrôle S et les troisièmes adresses A-ecc, M-ecc.

Les moyens de commande MCMD comportent ici un module BMCM, par exemple une logique de contrôle délivrant le signal de commande SCECC, ainsi que le multiplexeur MX recevant ce signal de commande SCEC sur son entrée de commande.

Bien entendu, en fonction de la valeur du signal SCECC, le signal WEN-cut5 et le signal CSEN-cut5 seront également délivrés à l'interface mémoire DM2INT couplée à la zone mémoire sram5.

Par contre, les signaux WEN-cut1-4 et CSEN-cut1-4 sont quant à eux uniquement délivrés à l'interface DMIINT couplée au premier domaine mémoire DM1.

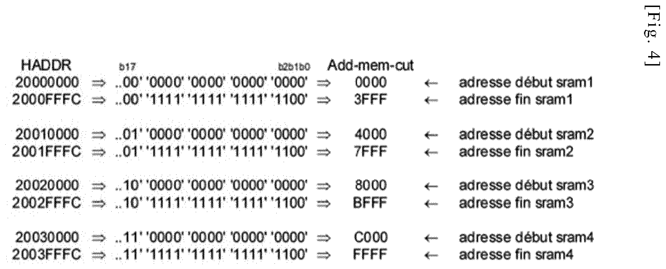

On se réfère maintenant plus particulièrement aux figures 4 à 7 pour illustrer un mode de mise en oeuvre du procédé selon l'invention.

La figure 4 illustre plus particulièrement l'obtention des premières adresses associées aux premières données destinées à être stockées dans les zones mémoire sram1-sram4 à partir des premières adresses initiales HADRR reçues par l'interface mémoire SRINT.

Dans l'exemple décrit ici, les adresses initiales HADDR sont des adresses codées sur 18 bits b0-b17.

La partie gauche de la figure 4 illustre ces adresses en format hexadécimal.

Les premières adresses Add-mem-cut sont obtenues par troncature des deux bits de poids faibles b0, b1 des adresses initiales.

Ainsi, la partie droite de la figure 4 illustre ces adresses Add-mem-cut en format hexadécimal.

Plus précisément, la valeur 0000 est l'adresse de début de la zone sram1 tandis que l'adresse 3FFF est l'adresse de fin de cette zone mémoire sram1.

L'adresse 4000 est l'adresse de début de la zone mémoire sram2 tandis que l'adresse 7FFF est l'adresse de fin de cette zone mémoire sram2.

L'adresse 8000 est l'adresse de début de la zone mémoire sram3 tandis que l'adresse BFFF est l'adresse de fin de cette zone mémoire sram3.

Enfin, l'adresse C000 est l'adresse de début de la zone mémoire sram4 tandis que l'adresse FFFF est l'adresse de fin de la zone mémoire sram4.

Bien entendu, les adresses mémoire Add-mem-cut5 associées aux données éventuelles destinées à être stockées dans la zone mémoire sram5 sont obtenues d'une façon analogue à ce qui vient d'être décrit.

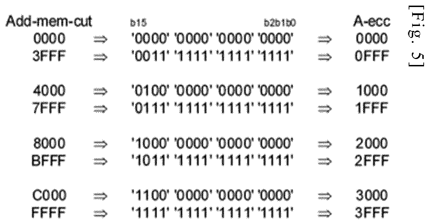

La figure 5 illustre un exemple d'obtention des troisièmes adresses A-ecc à partir des premières adresses Add-mem-cut.

Plus précisément, là encore, on effectue une troncature de deux bits des adresses Add-mem-cut pour obtenir l'adresse A-ecc de la rangée correspondante dans la zone mémoire sram5.

Plus précisément, cette troncature est une troncature des deux bits de poids faible b0-bl de l'adresse Add-mem-cut.

Ainsi, les bits de contrôle S associés aux données stockées dans la zone mémoire sram1 seront écrits entre les adresses 000 et 0FFF de la zone mémoire sram5.

Les bits de contrôle associés aux données écrites dans la zone mémoire sram2 seront stockés entre les adresses 1000 et 1FFF de la zone mémoire sram5.

Les bits de contrôle associés aux données écrites dans la zone mémoire sram3 seront stockés entre les adresses 2000 et 2FFF de la zone mémoire sram5.

Enfin, les bits de contrôle associés aux données écrites dans la zone mémoire sram4 seront stockés entre les adresses 3000 et 3FFF de la zone mémoire sram5.

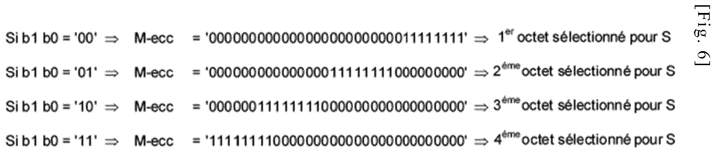

Enfin, comme illustré sur la figure 6, le masque M-ecc dépend de la valeur des deux bits de poids faible b1, b0 de l'adresse Add-mem-cut.

Plus précisément, si ces deux bits b1, b0 sont égaux à 0, alors le premier octet de M-ecc est égal à 1, les autres bits étant égaux à 0, ce qui signifie que l'on sélectionne, pour stocker les bits de contrôle S, le premier octet de la rangée correspondante.

Si les deux bits b1, b0 valent respectivement 0 et 1, alors c'est cette fois-ci le deuxième octet du masque M-ecc qui vaut 1 ce qui signifie que l'on sélectionne le deuxième octet de la rangée pour stocker les bits de contrôle S.

Si les bits b1, b0 valent respectivement 1 et 0, c'est cette fois-ci le troisième octet de M-ecc qui vaut 1 ce qui correspond à une sélection du troisième octet de la rangée correspondante pour stocker les bits de contrôle S.

Enfin, si les deux bits b1 et b0 valent tous deux 1, alors c'est le quatrième octet de M-ecc qui vaut 1 ce qui correspond à une sélection du quatrième octet de la rangée correspondante pour stocker les bits de contrôle.

Bien entendu, cette façon de déterminer M-ecc vaut également pour la détermination de Mask-mem-cut1-4 et Mask-mem-cut5 de façon à sélectionner pour chaque octet d'un mot de données à stocker, l'octet correspondant dans la rangée adressée.

Ainsi par exemple si l'on souhaite stocker un octet de donnée à l'adresse initiale HADDR égale à 0x2001ABC8, la première adresse sera égale, après troncature de l'adresse initiale, à 6AF2 ce qui correspond à une première adresse Add-mem-cut2 d'une rangée de la deuxième zone mémoire sram2.

Quant au mot de 7 bits formant le mot S des bits de contrôle associé au nouveau mot de 32 bits stocké dans la rangée, l'adresse A-ecc de la rangée correspondante dans la zone mémoire sram5, vaut après troncature de la première adresse Add-mem-cut2, 1ABC.

Le masque M-ecc associé à cette adresse de rangée indique, puisque les deux bits de poids faibles b1, b0 de la première adresse valent respectivement 1 et 0, une sélection du troisième octet de cette rangée pour stocker ce mot de contrôle S.

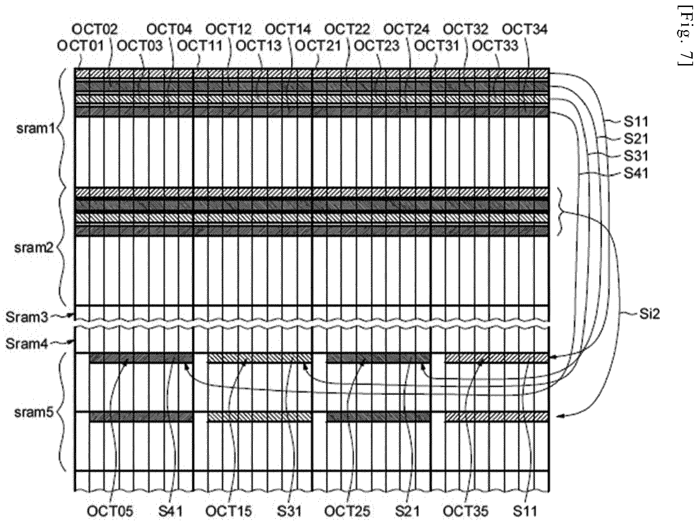

On se réfère maintenant plus particulièrement à la figure 7 pour illustrer un exemple de mise en oeuvre du procédé selon l'invention.

Dans cet exemple, on suppose que toutes les zones mémoire sram1 à sram2 et sram5 ont une taille mémoire de 64 kbits avec une largeur de mot de 32 bits.

En conséquence, chaque zone mémoire comporte 2048 rangées, chaque rangée pouvant contenir un mot de 32 bits (4 octets).

Le code correcteur d'erreurs est appliqué. Chaque mot de contrôle associé à un mot de données de 32 bits contient 7 bits de contrôle.

En appliquant les règles de détermination des adresses et des masques mentionnés ci-avant, on voit que l'ensemble S 11 des bits de contrôle associés aux quatre octets 0CT01, OCT11, OCT21 et OCT31 de la première rangée de la zone mémoire sram1 va être stocké dans l'octet OCT35 de la première rangée de la zone mémoire sram5.

De même, le mot S21 de bits de contrôle associé aux quatre octets OCT02, OCT12, OCT22 et OCT32 de la deuxième rangée de la zone mémoire sram1, sera stocké dans l'octet OCT25 de la première rangée de la mémoire sram5.

Le mot S31 de bits de contrôle associé aux quatre octets OCT03, OCT13, OCT23 et OCT33 de la troisième rangée de la mémoire sram1 sera stocké dans l'octet OCT15 de la première rangée de la mémoire sram5.

Enfin, le mot S41 de bits de contrôle associé aux quatre octets OCT04, OCT14, OCT24 et OCT34 de la quatrième rangée de la zone mémoire sram1 sera stocké dans l'octet OCT05 de la première rangée de la zone mémoire sram5.

Et, ce processus de stockage des différents mots de bit de contrôle associés aux différentes rangées va se poursuivre.

D'une façon générale, les quatre mots de bits de contrôle associés aux quatre mots de quatre rangées consécutives d'une zone mémoire srami, i variant de 1 à 4, seront stockés dans une seule et même rangée de la zone mémoire sram5.

De ce fait, les mots de contrôle associés aux 2048 rangées de la zone mémoire sram1 seront stockés dans 512 rangées de la mémoire sram5.

Et, les 512 rangées suivantes de la mémoire sram5 seront dédiées au stockage des mots Si2 de bits de contrôle associés aux données stockées dans la zone mémoire sram2.

## Revendications

1. Système comprenant un dispositif de mémoire (DMM) comportant un premier domaine mémoire (DM1) destiné à stocker des premières données à des premières adresses et un deuxième domaine mémoire (DM2) destiné à stocker, sur commande, soit des deuxièmes données à des deuxièmes adresses soit des bits de contrôle de code correcteur d'erreurs associés aux premières données à des troisièmes adresses, **caractérisée en ce que** les deuxièmes données peuvent être stockées dans le deuxième domaine seulement lorsque le code correcteur d'erreurs n'est pas utilisé.

2. Système selon la revendication 1, comprenant en outre des moyens de traitement (MT) configurés pour déterminer les troisièmes adresses à partir des premières adresses.

3. Système selon la revendication 1 ou 2, comprenant en outre une interface (SRINT) configurée pour recevoir les premières données ainsi que des premières adresses initiales associées aux premières données et éventuellement les deuxièmes données ainsi que des deuxièmes adresses initiales associées à ces deuxièmes données, et pour délivrer les premières adresses et les deuxièmes adresses à partir des premières adresses initiales et des deuxièmes adresses initiales, un module de code correcteur d'erreurs (MECC) configuré pour déterminer les bits de contrôle associés auxdites premières données, des moyens de traitement (MT) configurés pour déterminer les troisièmes adresses desdits bits de contrôle, et des moyens de commande (MCMD) configurés pour délivrer au deuxième domaine mémoire soit lesdites deuxièmes données et lesdites deuxièmes adresses soit lesdits bits de contrôle et les troisièmes adresses.

4. Système selon l'une des revendications précédentes, dans lequel les troisièmes adresses sont obtenues par des troncatures des premières adresses.

5. Système selon l'une des revendications précédentes, dans lequel le premier domaine mémoire (DM1) comprend au moins une première zone mémoire ayant une première taille mémoire et le deuxième domaine mémoire (DM2) comporte une deuxième zone mémoire (sram5) ayant également ladite première taille mémoire.

6. Système selon la revendication 5, dans lequel ladite au moins une première zone mémoire et la deuxième zone mémoire comportent des rangées, et les moyens de traitement sont configurés pour déterminer lesdites troisièmes adresses de sorte que les bits de contrôle associés aux premières données stockées dans un premier nombre de rangées successives de ladite au moins une première zone mémoire (sram1), soient stockés dans un deuxième nombre de rangées de la deuxième zone mémoire (sram5) inférieur au premier nombre.

7. Système selon la revendication 6, dans lequel chaque rangée de ladite au moins une première zone mémoire (sram1) et chaque rangée de la deuxième zone mémoire (sram5) sont configurées pour stocker des mots de p octets, et les moyens de traitement (MT) sont configurés pour déterminer lesdites troisièmes adresses de sorte que les bits de contrôle associés aux premières données stockées dans p rangées successives de ladite au moins une première zone mémoire (sram1), soient stockés dans les p octets d'une rangée de la deuxième zone mémoire (sram5).

8. Système selon l'une des revendications 5 à 7, dans lequel le premier domaine mémoire (DM1) comporte plusieurs premières zones mémoires (sram1-sram4) ayant chacune ladite première taille mémoire.

9. Système selon les revendications 7 et 8, dans lequel le premier domaine mémoire (DM1) comporte k.p premières zones mémoire (sram1-sram4) et le deuxième domaine mémoire (DM2) comporte k deuxièmes zones mémoires (sram5), k étant un entier supérieur ou égal à 1.

10. Système selon l'une des revendications précédentes, dans lequel le dispositif de mémoire (DMM) est un dispositif de mémoire volatile.

11. Procédé de gestion de l'espace mémoire d'un dispositif de mémoire comportant un premier domaine mémoire (DM1) et un deuxième domaine mémoire (DM2), le procédé comprenant un stockage de premières données à des premières adresses dans le premier domaine (DM1), et, sur commande, soit un stockage dans le deuxième domaine mémoire (DM2) de deuxièmes données à des deuxièmes adresses soit un stockage dans le deuxième domaine mémoire (DM2) de bits de contrôle de code correcteur d'erreurs associés aux premières données à des troisièmes adresses, **caractérisée en ce que** les deuxièmes données peuvent être stockées dans le deuxième domaine seulement lorsque le code correcteur d'erreurs n'est pas utilisé.

12. Procédé selon la revendication 11, comprenant une détermination des troisièmes adresses à partir des premières adresses.

13. Procédé selon la revendication 12, dans lequel la détermination des troisièmes adresses comporte des troncatures des premières adresses.

14. Procédé selon l'une des revendications 11 à 13, comprenant
une réception des premières données ainsi que de premières adresses initiales associées aux premières données et éventuellement une réception des deuxièmes données ainsi que des deuxièmes adresses initiales associées à ces deuxièmes données,
une élaboration des premières adresses à partir des premières adresses initiales et une élaboration des deuxièmes adresses à partir des deuxièmes adresses initiales,
une détermination des bits de contrôle associés auxdites premières données, une détermination des troisièmes adresses desdits bits de contrôle, et,
sur commande, une délivrance au deuxième domaine mémoire (DM2) soit desdites deuxièmes données et desdites deuxièmes adresses soit desdits bits de contrôle et des troisièmes adresses.

15. Procédé selon l'une des revendications 11 à 14, dans lequel le premier domaine mémoire (DM1) comprend au moins une première zone mémoire ayant une première taille mémoire et le deuxième domaine mémoire (DM2) comporte une deuxième zone mémoire (sram5) ayant également ladite première taille mémoire.

16. Procédé selon la revendication 15, dans lequel ladite au moins une première zone mémoire et la deuxième zone mémoire comportent des rangées, et les bits de contrôle associés aux premières données stockées dans un premier nombre de rangées successives de ladite au moins une première zone mémoire (sram1), sont stockés dans un deuxième nombre de rangées de la deuxième zone mémoire (sram5) inférieur au premier nombre.

17. Procédé selon la revendication 16, dans lequel chaque rangée de ladite au moins une première zone mémoire (sram1) et chaque rangée de la deuxième zone mémoire (sram5) sont configurées pour stocker des mots de p octets, et les bits de contrôle associés aux premières données stockées dans p rangées successives de ladite au moins une première zone mémoire (sram1), sont stockés dans les p octets d'une rangée de la deuxième zone mémoire (sram5).

18. Procédé selon l'une des revendications 15 à 17, dans lequel le premier domaine mémoire (DM1) comporte plusieurs zones mémoires (sram1-sram4) ayant chacune ladite première taille mémoire.

19. Procédé selon les revendications 17 et 18, dans lequel le premier domaine mémoire (DM1) comporte k.p premières zones mémoire (sram1-sram4) et le deuxième domaine mémoire (DM2) comporte k deuxièmes zones mémoires (sram5), k étant un entier supérieur ou égal à 1.

20. Procédé selon l'une des revendications 11 à 19, dans lequel le dispositif de mémoire (DMM) est un dispositif de mémoire volatile.

## Patentansprüche

1. System, umfassend eine Speichervorrichtung (DMM), umfassend einen ersten Speicherbereich (DM1), der dazu vorgesehen ist, erste Daten an ersten Adressen zu speichern, und einen zweiten Speicherbereich (DM2), der dazu vorgesehen ist, auf Befehl entweder zweite Daten an zweiten Adressen oder Fehlerkorrekturcode-Kontrollbits, die mit den ersten Daten assoziiert sind, an dritten Adressen zu speichern, **dadurch gekennzeichnet, dass** die zweiten Daten nur in dem zweiten Bereich gespeichert werden können, wenn der Fehlerkorrekturcode nicht verwendet wird.

2. System nach Anspruch 1, weiterhin umfassend Verarbeitungsmittel (MT), die zum Bestimmen der dritten Adressen aus den ersten Adressen konfiguriert sind.

3. System nach Anspruch 1 oder 2, weiterhin umfassend eine Schnittstelle (SRINT), die zum Empfangen der ersten Daten sowie ersten Anfangsadressen, die mit den ersten Daten assoziiert sind, und gegebenenfalls den zweiten Daten sowie zweiten Anfangsadressen, die mit diesen zweiten Daten assoziiert sind, und zum Liefern der ersten Adressen und der zweiten Adressen aus den ersten Anfangsadressen und den zweiten Anfangsadressen konfiguriert ist, ein Fehlerkorrekturcode-Modul (MECC), das zum Bestimmen der Kontrollbits, die mit den ersten Adressen assoziiert sind, konfiguriert ist, Verarbeitungsmittel (MT), die zum Bestimmen der dritten Adressen der Kontrollbits konfiguriert sind, und Steuerungsmittel (MCMD), die zum Liefern entweder der zweiten Daten und der zweiten Adressen oder der Kontrollbits und der dritten Adressen an den zweiten Speicherbereich konfiguriert sind.

4. System nach einem der vorhergehenden Ansprüche, wobei die dritten Adressen durch Trunkierungen der ersten Adressen erhalten werden.

5. System nach einem der vorhergehenden Ansprüche, wobei der erste Speicherbereich (DM1) mindestens eine erste Speicherzone mit einer ersten Speichergröße umfasst und der zweite Speicherbereich (DM2) eine zweite Speicherzone (sram5) mit ebenfalls der ersten Speichergröße umfasst.

6. System nach Anspruch 5, wobei die mindestens eine Speicherzone und die zweite Speicherzone Reihen umfassen und die Verarbeitungsmittel zum Bestimmen der dritten Adressen konfiguriert sind, so dass die Kontrollbits, die mit den ersten Daten assoziiert sind, die in einer ersten Anzahl von aufeinanderfolgenden Reihen der mindestens einen ersten Speicherzone (sram1) gespeichert sind, in einer zweiten Anzahl von Reihen der zweiten Speicherzone (sram5), die kleiner als die erste Anzahl ist, gespeichert werden.

7. System nach Anspruch 6, wobei jede Reihe der mindestens einen ersten Speicherzone (sram1) und jede Reihe der zweiten Speicherzone (sram5) zum Speichern von Wörtern von p Bytes konfiguriert sind und die Verarbeitungsmittel (MT) zum Bestimmen der dritten Adressen konfiguriert sind, so dass die Kontrollbits, die mit den ersten Daten assoziiert sind, die in p aufeinanderfolgenden Reihen der mindestens einen ersten Speicherzone (sram1) gespeichert sind, in den p Bytes einer Reihe der zweiten Speicherzone (sram5) gespeichert werden.

8. System nach einem der Ansprüche 5 bis 7, wobei der erste Speicherbereich (DM1) mehrere erste Speicherzonen (sram1-sram4) mit jeweils der ersten Speichergröße umfasst.

9. System nach den Ansprüchen 7 und 8, wobei der erste Speicherbereich (DM1) k.p erste Speicherzonen (sram1-sram4) umfasst und der zweite Speicherbereich (DM2) k zweite Speicherzonen (sram5) umfasst, wobei k eine ganze Zahl größer als oder gleich 1 ist.

10. System nach einem der vorhergehenden Ansprüche, wobei die Speichervorrichtung (DMM) eine flüchtige Speichervorrichtung ist.

11. Verfahren zur Verwaltung des Speicherplatzes einer Speichervorrichtung, umfassend einen ersten Speicherbereich (DM1) und einen zweiten Speicherbereich (DM2), wobei das Verfahren eine Speicherung von ersten Daten an ersten Adressen in dem ersten Bereich (DM1) und auf Befehl entweder eine Speicherung von zweiten Daten an zweiten Adressen in dem zweiten Speicherbereich (DM2) oder eine Speicherung von Fehlerkorrekturcode-Kontrollbits, die mit den ersten Daten assoziiert sind, an dritten Adressen in dem zweiten Speicherbereich (DM2) umfasst, **dadurch gekennzeichnet, dass** die zweiten Daten nur in dem zweiten Bereich gespeichert werden können, wenn der Fehlerkorrekturcode nicht verwendet wird.

12. Verfahren nach Anspruch 11, umfassend eine Bestimmung von dritten Adressen aus ersten Adressen.

13. Verfahren nach Anspruch 12, wobei die Bestimmung von dritten Adressen Trunkierungen von ersten Adressen umfasst.

14. Verfahren nach einem der Ansprüche 11 bis 13, umfassend
einen Empfang von ersten Daten sowie ersten Anfangsadressen, die mit den ersten Daten assoziiert sind, und gegebenenfalls einen Empfang von zweiten Daten sowie zweiten Anfangsadressen, die mit diesen zweiten Daten assoziiert sind,
eine Erstellung von ersten Adressen aus ersten Anfangsadressen und eine Erstellung von zweiten Adressen aus zweiten Anfangsadressen,
eine Bestimmung von Kontrollbits, die mit den ersten Adressen assoziiert sind, eine Bestimmung von dritten Adressen der Kontrollbits und
auf Befehl eine Lieferung entweder der zweiten Daten und der zweiten Adressen oder der Kontrollbits und der dritten Adressen an den zweiten Speicherbereich (DM2).

15. Verfahren nach einem der Ansprüche 11 bis 14, wobei der erste Speicherbereich (DM1) mindestens eine erste Speicherzone (DM1) mit einer ersten Speichergröße umfasst und der zweite Speicherbereich (DM2) eine zweite Speicherzone (sram5) mit ebenfalls der ersten Speichergröße umfasst.

16. Verfahren nach Anspruch 15, wobei die mindestens eine erste Speicherzone und die zweite Speicherzone Reihen umfassen und die Kontrollbits, die mit den ersten Daten assoziiert sind, die in einer ersten Anzahl von aufeinanderfolgenden Reihen der mindestens einen ersten Speicherzone (sram1) gespeichert sind, in einer zweiten Anzahl von Reihen der zweiten Speicherzone (sram5), die kleiner als die erste Anzahl ist, gespeichert werden.

17. Verfahren nach Anspruch 16, wobei jede Reihe der mindestens einen ersten Speicherzone (sram1) und jede Reihe der zweiten Speicherzone (sram5) zum Speichern von Wörtern von p Bytes konfiguriert sind und die Kontrollbits, die mit den ersten Daten assoziiert sind, die in p aufeinanderfolgenden Reihen der mindestens einen ersten Speicherzone (sram1) gespeichert sind, in den p Bytes einer Reihe der zweiten Speicherzone (sram5) gespeichert werden.

18. Verfahren nach einem der Ansprüche 15 bis 17, wobei der erste Speicherbereich (DM1) mehrere erste Speicherzonen (sram1-sram4) mit jeweils der ersten Speichergröße umfasst.

19. Verfahren nach den Ansprüchen 17 und 18, wobei der erste Speicherbereich (DM1) k.p erste Speicherzonen (sram1-sram4) umfasst und der zweite Speicherbereich (DM2) k zweite Speicherzonen (sram5) umfasst, wobei k eine ganze Zahl größer als oder gleich 1 ist.

20. Verfahren nach einem der Ansprüche 11 bis 19, wobei die Speichervorrichtung (DMM) eine flüchtige Speichervorrichtung ist.

## Claims

1. A system comprising a memory device (DMM) including a first memory domain (DM1) intended to store first data at first addresses and a second memory domain (DM2) intended to store, on command, either second data at second addresses or error correcting code check bits associated with the first data at third addresses, **characterised in that** the second data can be stored in the second domain only when the error correcting code is not used.

2. The system according to claim 1, further comprising processing means (MT) configured to determine the third addresses from the first addresses.

3. The system according to claim 1 or 2, further comprising an interface (SRINT) configured to receive the first data as well as first initial addresses associated with the first data and possibly the second data as well as second initial addresses associated with these second data, and to deliver the first addresses and the second addresses from first initial addresses and second initial addresses, an error correcting code module (MECC) configured to determine the check bits associated with said first data, processing means (MT) configured to determine the third addresses of said check bits, and control means (MCMD) configured to deliver either said second data and said second addresses or said check bits and the third addresses to the second memory domain.

4. The system according to one of the preceding claims, wherein the third addresses are obtained by truncations of the first addresses.

5. The system according to one of the preceding claims, wherein the first memory domain (DM1) comprises at least one first memory area having a first memory size and the second memory domain (DM2) includes a second memory area (sram5) also having said first memory size.

6. The system according to claim 5, wherein said at least one first memory area and the second memory area include rows, and the processing means are configured to determine said third addresses such that the check bits associated with the first data stored in a first number of successive rows of said at least one first memory area (sram1), are stored in a second number of rows of the second memory area (sram5) which is less than the first number.

7. The system according to claim 6, wherein each row of said at least one first memory area (sram1) and each row of the second memory area (sram5) are configured to store words of p bytes, and the processing means (MT) are configured to determine said third addresses such that the check bits associated with the first data stored in p successive rows of said at least one first memory area (sram1), are stored in the p bytes of a row of the second memory area (sram5).

8. The system according to one of claims 5 to 7, wherein the first memory domain (DM1) includes several first memory areas (sram1-sram4) each having said first memory size.

9. The system according to claims 7 and 8, wherein the first memory domain (DM1) includes k.p first memory areas (sram1-sram4) and the second memory domain (DM2) includes k second memory areas (sram5), k being an integer which is greater than or equal to 1.

10. The system according to one of the preceding claims, wherein the memory device (DMM) is a volatile memory device.

11. A method for managing the memory space of a memory device including a first memory domain (DM1) and a second memory domain (DM2), the method comprising a storage of first data at first addresses in the first domain (DM1), and, on command, either a storage in the second memory domain (DM2) of second data at second addresses or a storage in the second memory domain (DM2) of error correcting code check bits associated with the first data at third addresses, **characterised in that** the second data can be stored in the second domain only when the error correcting code is not used.

12. The method according to claim 11, comprising a determination of the third addresses from the first addresses.

13. The method according to claim 12, wherein the determination of the third addresses includes truncations of the first addresses.

14. The method according to one of claims 11 to 13, comprising a reception of the first data as well as first initial addresses associated with the first data and possibly a reception of the second data as well as the second initial addresses associated with these second data,
a development of the first addresses from the first initial addresses and a development of the second addresses from the second initial addresses,
a determination of the check bits associated with said first data, a determination of the third addresses of said check bits, and,
on command, a delivery either of said second data and said second addresses or of said check bits and the third addresses to the second memory domain (DM2).

15. The method according to one of claims 11 to 14, wherein the first memory domain (DM1) comprises at least one first memory area having a first memory size and the second memory domain (DM2) includes a second memory area (sram5) also having said first memory size.

16. The method according to claim 15, wherein said at least one first memory area and the second memory area include rows, and the check bits associated with the first data stored in a first number of successive rows of said at least one first memory area (sram1), are stored in a second number of rows of the second memory area (sram5) which is less than the first number.

17. The method according to claim 16, wherein each row of said at least one first memory area (sram1) and each row of the second memory area (sram5) are configured to store words of p bytes, and the check bits associated with the first data stored in p successive rows of said at least one first memory area (sram1), are stored in the p bytes of a row of the second memory area (sram5).

18. The method according to one of claims 15 to 17, wherein the first memory domain (DM1) includes several memory areas (sram1-sram4) each having said first memory size.

19. The method according to claims 17 and 18, wherein the first memory domain (DM1) includes k.p first memory areas (sram1-sram4) and the second memory domain (DM2) includes k second memory areas (sram5), k being an integer which is greater than or equal to 1.

20. The method according to one of claims 11 to 19, wherein the memory device (DMM) is a volatile memory device.
